Europäisches Patentamt

European Patent Office

Office européen des brevets

(19)

(11) Veröffentlichungsnummer: **0 288 729 B1**

## (12) EUROPÄISCHE PATENTSCHRIFT

(45) Veröffentlichungstag der Patentschrift: **27.11.91**

(51) Int. Cl.⁵: **H02H 7/00, H01F 7/22**

(21) Anmeldenummer: **88104372.3**

(22) Anmeldetag: **18.03.88**

(54) **Quenchausbreitungseinrichtung für einen supraleitenden Magneten.**

(30) Priorität: **30.03.87 DE 3710519**

(43) Veröffentlichungstag der Anmeldung:
**02.11.88 Patentblatt 88/44**

(45) Bekanntmachung des Hinweises auf die
Patenterteilung:
**27.11.91 Patentblatt 91/48**

(84) Benannte Vertragsstaaten:
**DE FR GB NL**

(56) Entgegenhaltungen:
**DE-A- 2 611 266**
**DE-A- 2 646 467**
**DE-A- 3 532 396**
**GB-A- 1 230 579**

(73) Patentinhaber: **SIEMENS AKTIENGESELL-**
**SCHAFT**
**Wittelsbacherplatz 2**
**W-8000 München 2(DE)**

(72) Erfinder: **Ries, Günter, Dr.**
**Schobertweg 2**
**W-8520 Erlangen(DE)**

**Beschreibung**

Die Erfindung bezieht sich auf eine Einrichtung zur Quenchausbreitung für einen supraleitenden Magneten mit mindestens einem Paar supraleitender Spulen, mit welcher Einrichtung bei einem in einem Störungsfall auftretenden Normalleitendwerden (Quench) einer ersten, bis dahin supraleitenden Spule des Spulenpaares auch die zweite Spule dieses Paares vom supraleitenden Betriebszustand in den normalleitenden Zustand mit Hilfe von thermisch mit den Spulen verbundenen Heizvorrichtungen zu überführen ist. Eine derartige Quenchausbreitungseinrichtung ist aus der EP-B-0 115 797 bekannt.

In größeren supraleitenden Magneten sind erhebliche Energiemengen zu speichern, die beispielsweise im MJ-Bereich liegen. Insbesondere derartige Magnete sind bei einem unbeabsichtigten Übergang vom supraleitenden Betriebszustand in den normalleitenden Zustand stark gefährdet, selbst wenn dieser auch als "Quench" bezeichnete Übergang zunächst nur in einem Teil des Magneten auftritt. Infolge der geringen Wärmekapazität der supraleitenden Spulenleiter des Magneten nimmt nämlich ein solcher Leiter nach einem Quench durch die dadurch bedingte Widerstandserhöhung sehr schnell eine hohe Temperatur an. Gleichzeitig steigt auch sein spezifischer Widerstand sehr rasch, wodurch die Erwärmung noch beschleunigt wird. Es kommt dabei zu elektrischen Überspannungen, welche die Isolation beanspruchen und bei einem Überschlag zu einer Beschädigung oder Zerstörung des Magneten führen können.

Größere supraleitende Magnete sind häufig aus mehreren supraleitenden Spulen bzw. Teilspulen oder -wicklungen aufgebaut. Um diese Spulen vor einer Beschädigung oder Zerstörung durch Überhitzung bzw. durch elektrische Überschläge zu schützen, werden vielfach besondere Schutzmaßnahmen vorgesehen. Diese Maßnahmen können insbesondere darin bestehen, daß man zur Spannungsbegrenzung die einzelnen Spulen jeweils mit ohmschen Schutzwiderständen (vgl. DE-OS 23 01 152), Halbleiterdioden (vgl. DE-OS 16 14 964) oder auch mit Spannungsableitern (DE-OS 17 64 369) überbrückt. Dann können aber bei einem Quench einer einzelnen Spule die Ströme der im allgemeinen in Serie geschalteten Spulen des Magneten einen stark unterschiedlichen zeitlichen Verlauf annehmen: Der Strom der gequenchten Spule nimmt hierbei ab, während er in den Nachbarspulen sogar ansteigen kann. In einem solchen Fall ist es oft wünschenswert, auch in weiteren oder allen Spulen des Magneten einen Quench auszulösen, z.B. um den gesamten Magneten zu entregen oder um die in Wärme umgesetzte magnetische Energie gleichmäßiger auf die einzelnen Spulen aufzuteilen. Oder aber es soll die Strom-und Feld-Verteilung während eines Spulenquenches günstig beeinflußt werden. Dies ist besonders wichtig, wenn der Magnet ein System aus paarweise symmetrisch aufgebauten Spulen darstellt. Bei einem Spulenpaar werden nämlich bei einem Quench die ansonsten symmetrische Stromverteilung und damit auch die Feldverteilung asymmetrisch. Entsprechendes gilt in der Folge auch für die Wechselwirkung der Spulen mit ihrer Umgebung, insbesondere mit induzierten Wirbelströmen in einem sie umgebenden Kryostaten oder mit sie umgebenden ferromagnetischen Teilen wie z.B. von einer Eisenabschirmung. Dann können erhebliche, eine kryogene Aufhängung der Spulen belastende magnetische Kräfte auftreten.

Man ist deshalb bestrebt, bei einem Quench einer Spule eines solchen Spulenpaares möglichst schnell auch in der symmetrisch dazu liegenden Spule Normalleitung auszulösen, um so die Stromverteilung in dem gesamten Magneten und damit auch die Kraftwirkung auf die Umgebung symmetrischer werden zu lassen. Die abzustützende Nettokraft auf die Spulenpaare und auf Kryostatenkomponenten kann so verringert werden.

Maßnahmen zur Beschleunigung einer Ausbreitung der normalleitenden Bereiche in einem mehrere Spulen umfassenden Magneten sind z.B. aus "IEEE Transactions on Magnetics", Vol. MAG-17, No. 5, Sept. 1981, Seiten 1815-1822 bekannt. Danach kann man eine Quenchausbreitung durch elektrische Heizelemente an den Spulen fördern, die von einem besonderen Quenchdetektor aktiviert und von einer externen Stromversorgung gespeist werden.

Aus Gründen der Zuverlässigkeit wird jedoch vielfach eine "passive" Quenchausbreitung für einen großen supraleitenden Magneten angestrebt. Eine entsprechende Einrichtung zeichnet sich dadurch aus, daß sie ihre spannungs-, temperatur- und kraftbegrenzende Funktion ohne den Einsatz und ohne die Betätigung aktiver Elemente wie z.B. von Quenchdetektoren, Schaltern und extern gespeisten Heizelementen ausübt.

Eine derartige passive Quenchausbreitungseinrichtung geht z.B. aus der Veröffentlichung "Proc. 6th Int.Conf. on Magnet Technology" (MT-6), Bratislava (CSSR), 28.8.-2.9.1977, Seiten 654 bis 662 hervor. Gemäß dieser Einrichtung ist ein supraleitender Magnet auf einem elektrisch gut leitenden Spulenkörper wie z.B. aus Reinstaluminium oder auf einer sekundären Kurzschlußwicklung aufzuwickeln. Diese übernimmt in einem Quenchfall transformatorisch einen Teil der Energie und heizt gleichzeitig die noch supraleitenden Teile des Magneten auf. Bei einer solchen Einrichtung treten jedoch hohe Verluste an dem Kühlmedium Helium bei normalem Auf- und Aberregen aufgrund induzierter Ströme auf. Bei zu hoher Umerregungsgeschwindigkeit besteht sogar die Gefahr einer unbeabsichtigten Quenchauslösung.

Auch die aus der eingangs genannten EP-B zu entnehmende Quenchausbreitungseinrichtung arbeitet passiv. Diese Einrichtung, die für einen supraleitenden Magneten mit mehreren einzelnen Spulen oder Teilspulen vorgesehen ist, enthält besondere Heizvorrichtungen in Form von Folien aus normalleitendem Material, die in gut-wärmeleitendem Kontakt mit einer jeweils zugeordneten Spule verbunden sind. Die in einem Quenchfall erforderlichen Betriebsspannungen für diese Heizelemente werden dabei aus einem Netzwerk von Quenchschutzwiderständen abgegriffen. Hierbei arbeitet jedoch die Quenchfortschaltung von der gequenchten Spule auf die übrigen Spulen verhältnismäßig langsam, so daß für eine entsprechend lange Übergangszeit in dem Magneten entsprechend ungleichmäßige Verhältnisse der Stromverteilung und damit der Kraftwirkung auftreten können.

Aufgabe der vorliegenden Erfindung ist es deshalb, die passive Quenchausbreitungseinrichtung der eingangs genannten Art dahingehend zu verbessern, daß diese Gefahr verringert ist, indem eine schnellere Magnetentregung ermöglicht wird.

Diese Aufgabe wird erfindungsgemäß mit den im Kennzeichen des Hauptanspruchs angegebenen Maßnahmen gelöst.

Die mit dieser Ausgestaltung der Quenchausbreitungseinrichtung verbundenen Vorteile sind insbesondere darin zu sehen, daß die einer quenchenden Spule zugeordnete zweite Spule eines Spulenpaares verhältnismäßig schnell in den normalleitenden Zustand überführt wird, ohne daß es besonderer externer (aktiver) Komponenten bedarf. Wegen der magnetisch engen Kopplung der Zusatzwicklungen mit ihren jeweils zugeordneten Spulen werden nämlich im Quenchfall einer Spule eines Spulenpaares in deren Zusatzwicklung Spannungen induziert, welche nun durch das als Heizer wirkende Gegenstück auf der zweiten Spule des Spulenpaares einen Heizstrom treibt und dort ebenfalls einen Quench auslöst. Vorteilhaft ist dabei besonders, daß der Aufbau der einem Spulenpaar zuzuordnenden beiden Zusatzwicklungen quasi-symmetrisch ist; d.h. die Rollen von Induktions- und Heizwicklung vertauschen sich je nach Quenchursprung. Bei einem betriebsmäßigen Auf- und Aberregen sind dabei wegen der antisymmetrischen Verschaltung der beiden Zusatzwicklungen Spannung und Heizleistung praktisch null. D.h., auch schnelles betriebsmäßiges Umerregen kann dann keinen Quench auslösen, und die durch die Zusatzwicklungen verursachten Verluste an kryogenem Kühlmittel sind entsprechend minimal.

Vorteilhafte Ausgestaltungen der erfindungsgemäßen Quenchausbreitungseinrichtung gehen aus den Unteransprüchen hervor.

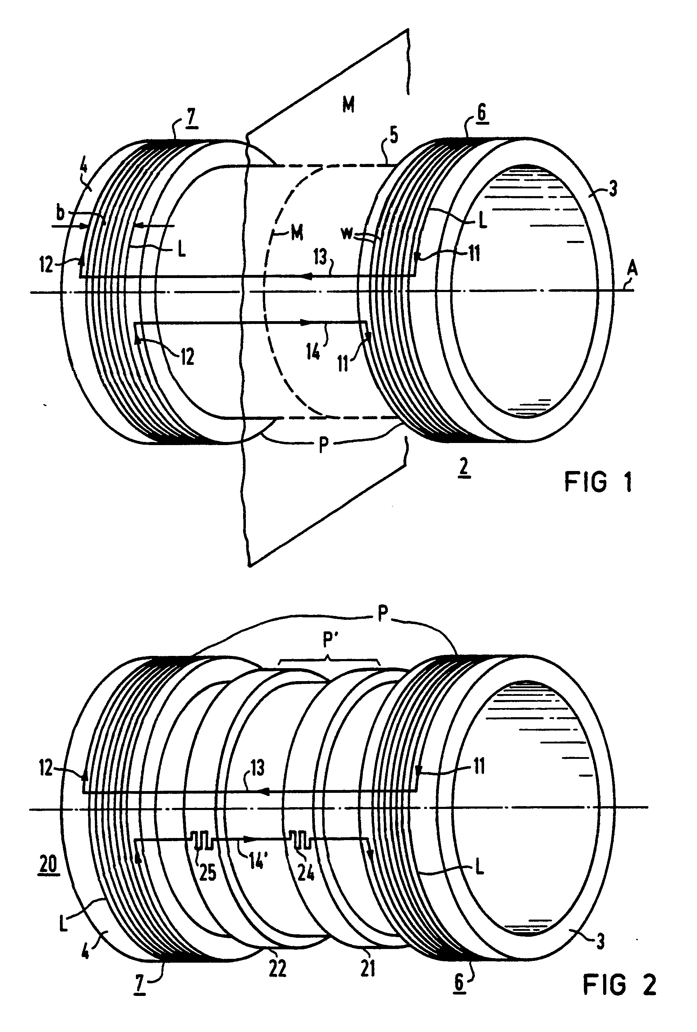

Zur weiteren Erläuterung der Erfindung wird nachfolgend auf die Zeichnung Bezug genommen, in deren Figur 1 eine erfindungsgemäße Quenchausbreitungseinrichtung veranschaulicht ist. Figur 2 zeigt eine spezielle Ausbildungsmöglichkeit einer derartigen Einrichtung.

Die erfindungsgemäße Quenchausbreitungseinrichtung kann vorteilhaft für alle supraleitenden Magnete vorgesehen werden, die mindestens ein Paar von supraleitenden Einzelspulen aufweisen. Entsprechende Magnete werden beispielsweise auf dem Gebiet der medizinischen Technik als Grundfeldmagnete für Anlagen zur Kernspintomographie eingesetzt (vgl. z.B. EP-B-0 011 335 oder EP-A-0 056 691). Solche Grundfeldmagnete enthalten im allgemeinen mehrere, beispielsweise vier oder sechs ringförmige supraleitende Einzelspulen, die bezüglich einer Mittelebene paarweise symmetrisch angeordnet sind. Diese supraleitenden Einzelspulen überbrückt man zweckmäßigerweise mit Quenchschutzwiderständen oder -dioden. Dann können aber bei einem Quench aufgrund der Unsymmetrie der Einzelspulenströme in den zu beiden Seiten der Mittelebene liegenden Spulen erhebliche axiale Kräfte zwischen diesen Spulen, kryogenen Schilden und gegebenenfalls einer vorhandenen Eisenabschirmung auftreten. Diese Kräfte sind bei einem Magnetspulensystem zur Kernspintomographie an den stirnseitigen Einzelspulen bei weiten am größten, da diese Spulen im allgemeinen die höchste Windungszahl aufweisen.

Dem in Figur 1 in Schrägansicht schematisch dargestellten Ausführungsbeispiel sind zwei derartige supraleitende Spulen im Bereich der Stirnseiten eines entsprechenden Magneten 2 zugrundegelegt. Diese zumindest weitgehend baugleichen und mit 3 bzw. 4 bezeichneten Spulen sind symmetrisch bezüglich einer gedachten Mittelebene M des Magneten angeordnet. Beispielsweise befinden sie sich auf einem rohrförmigen Träger 5 um eine Achse A, dessen Schnittlinie mit der fiktiven Mittelebene M gestrichelt eingezeichnet ist. Diese ein Spulenpaar P bildenden Spulen 3 und 4 sind außerdem erfindungsgemäß mit einer Einrichtung zur Quenchausbreitung bzw. -fortschaltung ausgestattet, um einen Quench, der in einer der beiden Spulen (z.B. in Spule 3) auftritt, möglichst schnell auf die andere Spule (Spule 4) des Spulenpaares P ausbreiten und damit einen mehr symmetrischen Stromabfall in den beiden Spulen bewirken zu können. Dann heben sich nämlich Wirbelstrom- bzw. Einzelnettokräfte großenteils auf, wobei für die Spulen erforderliche, kryogene Abstützungen dementsprechend entlastet werden.

Die erfindungsgemäße Einrichtung zur Quenchausbreitung weist je eine einlagige Zusatzwicklung 6 bzw. 7 aus mindestens einem diskreten, band-oder drahtförmigen, isolierten Leiter L auf. Sie können aber auch aus mehreren Leitern aufgebaut werden. Aus diesem aus normalleitendem Material mit vorbestimmtem spezifischen elektrischen Widerstand $\rho$ bestehenden Leiter L sind nun jeweils mehrere Windungen w als die Zusatzwicklungen 6, 7 auf der jeweils zugeordneten Spule 3 bzw. 4 so angeordnet, daß ein guter thermischer Kontakt zur jeweiligen Spule gewährleistet ist. Selbstverständlich können stattdessen oder zusätzlich auch die Windungen w der Zusatzwicklungen an der Unterseite oder an mindestens einer der schmalseitigen Stirnflächen ihrer zugeordneten Spulen angebracht sein. Die beiden Zusatzwicklungen 6 und 7 sind so miteinander verschaltet, d.h. kurzgeschlossen, daß die durch Pfeile 11 angedeutete Stromflußrichtung in der Zwischenspule 6 entgegengesetzt zu der durch Pfeile 12 veranschaulichten Stromflußrichtung in der Zusatzwicklung 7 verläuft. Die erforderlichen beiden axialen Verbindungsleiter zwischen den beiden Zusatzwicklungen 6 und 7 sind in der Figur mit 13 und 14 bezeichnet. Zum Rest des Magneten 2 besteht von den Zusatzwicklungen 6 und 7 aus keine elektrische Verbindung.

Bei einem beispielsweise in der Spule 3 angenommenen Spulenquench wird dann in der magnetisch eng damit gekoppelten Zusatzwicklung 6 eine Spannung induziert, welche nun durch das als Heizer wirkende Gegenstück in Form der Zusatzwicklung 7 auf der zweiten Spule 4 einen Heizstrom treibt und somit dort ebenfalls einen Quench auslöst.

Der Aufbau der erfindungsgemäßen Einrichtung zur Quenchausbreitung ist also quasi-symmetrisch; d.h., die Rollen von Induktionswicklung (z.B. Zusatzwicklung 6) und Heizwicklung (Zusatzwicklung 7) vertauschen sich je nach Quenchursprung. Bei einem betriebsmäßigen Auf- und Aberregen des Magneten sind hingegen Spannung und Heizleistung minimal wegen der antisymmetrischen Verschaltung der beiden Zusatzwicklungen 6 und 7.

Eine schnelle Quenchauslösung verlangt eine gute elektrische Leitfähigkeit der Zusatzwicklungen. Andererseits soll der elektrische Widerstand der Zusatzwicklung auf der sich erwärmenden, gequenchten Spule temperaturbedingt nicht zu schnell zunehmen, weil dies den induzierten Strom schwächt. Für den Leiter L wird deshalb vorteilhaft ein Material gewählt, dessen spezifischer elektrischer Widerstand $\rho$ bei 4,2 K zwischen $10^{-9}$ und $10^{-11}$ $\Omega$ . m liegt. Damit ferner eine thermisch angekoppelte Wicklung noch im Bereich des temperaturabhängigen Restwiderstandes arbeiten kann, sollte ein Wert des Restwiderstandsverhältnisses $\rho$ (300 K)/ $\rho$ (4,2 K) zwischen ungefähr 50 bis 500 nicht überschritten werden. Mit einlagigen Zusatzwicklungen aus band oder drahtförmigem Kupfer oder Aluminium direkt auf den jeweiligen Spulen lassen sich die genannten Forderungen ohne weiteres erfüllen. Dabei wird vorteilhaft als Material das Stabilisierungsmaterial der Supraleiter vorgesehen, aus denen die supraleitenden Spulen aufgebaut sind. Außerdem wählt man vorteilhaft für den Leiter L der Zusatzwicklungen einen Drahtdurchmesser, der ähnlich dem des Supraleiters der zugeordneten Spule ist. Es kann so ein guter Wärmekontakt und eine einfache Wickeltechnik gewährleistet werden. Hierzu müssen die Zusatzwicklungen straff auf die jeweiligen Spulen aufgewickelt werden, da sonst die Lorentzkraft auf der heizenden Seite den Leiter von der Spule abheben und den thermischen Kontakt verschlechtern kann. Die Windungszahl hat dabei praktisch keinen Einfluß auf die Wirkung; d.h., es genügen wenige dicht bewickelte Zentimeter. Aus Gründen einer hinreichenden Wärmediffusion ist es vorteilhaft, wenn die Zusatzwicklungen aus dicht bei dicht gewickelten Windungen hergestellt werden, wobei eine axiale Mindestbreite b der Wicklungen von 2 cm vorgesehen wird.

Für eine elektrische Isolation zwischen den Zusatzwicklungen und ihren zugeordneten Spulen genügt im allgemeinen eine normale Drahtisolation, die gegebenenfalls noch durch eine dünne isolierende Folie verstärkt ist. Andererseits müssen die Zusatzwicklungen gegenüber dem die Spulen kühlenden kryogenen Medium Helium hinreichend thermisch isoliert sein, um so eine zu schnelle Abfuhr der Heizleistung der Zusatzwicklungen im Quenchfalle zu unterbinden. Die Zusatzwicklungen können deshalb gegenüber dem kryogenen Medium z.B. durch wenige mm starke Schichten aus Wachs oder Kunstharz thermisch isoliert sein.

Für eine grobe Abschätzung der Wirkung einer erfindungsgemäßen Quenchausbreitungseinrichtung sei angenommen, daß der die Spulen und ihre jeweils zugeordnete Zusatzwicklung durchsetzende magnetische Fluß und damit die induzierte Spannung $U_i$/Windung etwa in derselben Größenordnung liegen. In einer voll durchgequenchten Spule ist $U_i$ etwa auch gleich dem resistiven Spannungsabfall $U_r$/Windung, wenn aller Strom im normalleitenden Stabilisierungsmaterial des Supraleiters der Spule fließt. Die Stromdichten $j_h$ in den Zusatzwicklungen sind dann proportional $U_i$ und $\rho^{-1}$ . Wählt man nun Kupfer als Material für die Zusatzwicklungen 6 und 7 mit einem $\rho$ (4,2 K) von ungefähr 1 bis 2 $\cdot$ $10^{-10} \Omega$. m, so läßt sich dort etwa die halbe Stromdichte $j_h$ wie im Leiter der zugeordneten supraleitenden Spule 3 oder 4 erzielen. Die Quenchausbreitung von der heizenden Zusatzwicklung in die oberste Spulenlage geschieht dann etwa in der Zeit, die in einer Spule der Stromdichte $j_h$ eine mit der Ausbreitungsgeschwindigkeit $V_r$ laufende Quenchzone für eine Lagendicke braucht. Entsprechend der Veröffentlichung "Proc. 6th Int. Cryogenic Engng. Conf. - ICEC 6", Grenoble, 11.-14.5.1976, Seiten 492 bis 496 (Figur 2) ist $V_r$ einige cm/sec; d.h. die Auslösezeit für einen Quench ist demnach einige 1/10 sec. Dies ist kurz genug gegenüber der Zeit bis zum Kraftmaximum von einigen sec., um die Belastung kryogener Spulenabstützungen effektiv zu reduzieren.

Bei dem Figur 1 zugrundegelegten Ausführungsbeispiel wurde davon ausgegangen, daß der Magnet 2 lediglich zwei zueinander symmetrisch angeordnete Spulen 3 und 4 aufweist, denen eine erfindungsgemäße Quenchausbreitungseinrichtung zugeordnet sein soll. Selbstverständlich kann der Magnet noch weitere Paare von supraleitenden Spulen enthalten, wobei für jedes weitere Paar oder auch nur für einzelne der Paare eine eigene Quenchausbreitungseinrichtung vorgesehen wird. Darüber hinaus ist es auch möglich, mehrere als Teilspulen oder Teilwicklungen eines Magneten anzusehende Spulen so zusammenzufassen, daß diese wiederum ein Paar von symmetrisch zueinander angeordneten Spulensätzen bilden. Das so entstandene Paar von Spulensätzen kann dann mit einer erfindungsgemäßen Quenchausbreitungseinrichtung ausgestattet werden, wobei jeweils eine Zusatzwicklung einem Spulensatz zuzuordnen ist. D.h., bei den in Figur 1 gezeigten Spulen 3 und 4 kann es sich nicht nur um jeweils eine einzige Spule handeln; vielmehr können sich die Spulen 3 und 4 jeweils aus mehreren einzelnen Spulen zu einem Spulensatz zusammensetzen.

Hat ein supraleitender Magnet mehr als ein Paar zueinander symmetrischer Einzelspulen, und ruft eines dieser Spulenpaare bei einem Quench einer seiner beiden Spulen wesentlich größere asymmetrische Kräfte auf als das mindestens eine weitere Spulenpaar, so ist es in diesem Fall möglich, lediglich den Spulen des Spulenpaares mit der größeren Kraftwirkung eine Quenchausbreitungseinrichtung gemäß Figur 1 zuzuordnen. Die übrigen, weniger kritischen Spulen lassen sich dann mit flächig ausgebildeten ohmschen Heizelementen quenchen, die in den Serienkreis der Zusatzwicklungen der Quenchausbreitungseinrichtung geschaltet sind. Ein entsprechendes Ausführungsbeispiel für einen Magneten mit zwei Paaren von supraleitenden Einzelspulen ist dem in Figur 2 schematisch gezeigten Ausführungsbeispiel zugrundegelegt. Dabei wurde eine Schrägansicht wie für Figur 1 gewählt. In den Figuren übereinstimmende Teile sind mit den gleichen Bezugszeichen versehen. Abweichend von der Darstellung nach Figur 1 weist der in Figur 2 gezeigte und mit 20 bezeichnete Magnet zwischen seinen ein äußeres Spulenpaar P ausbildenden stirnseitigen Spulen 3 und 4 ein weiteres, inneres Spulenpaar P' mit Spulen 21 und 22 auf, die beispielsweise eine geringere Amperewindungszahl haben als ihre jeweils benachbarten supraleitenden Spulen 3 bzw. 4. Die für diesen Magneten 20 vorgesehene Quenchausbreitungseinrichtung enthält wiederum die beiden Zusatzwicklungen 6 und 7 um die zugeordneten supraleitenden Spulen 3 bzw. 4. Diese beiden Zusatzwicklungen 6, 7 sind untereinander durch axial verlaufende Verbindungsleiter 13 und 14' zusammengeschaltet, wobei die vorbestimmten Stromflußrichtungen gewährleistet sind. An den Spulen 21 und 22 des inneren Spulenpaares P' sind nun in gut-wärmeleitendem Kontakt an sich bekannte ohmsche Heizelemente 24 und 25 hinreichender Ausdehnung aufgebracht, die in mindestens einen der beiden Verbindungsleiter, beispielsweise in den Verbindungsleiter 14' in Serie geschaltet sind. Der elektrische Serienwiderstand beider Heizelemente zusammen sollte dabei vorteilhaft das 1- bis 10-Fache des Serienwiderstandes beider Zusatzwicklungen 6 und 7 betragen. Im Falle eines Quenches einer der beiden Spulen (3 oder 4) des äußeren Spulenpaares P wird dann in dem Serienkreis von der quenchenden Spule ein Heizstrom hervorgerufen, der die ohmschen Flächenheizelemente 24 und 25 so weit aufheizen kann, daß auch die beiden ihnen zugeordneten Spulen 21 und 22 des inneren Spulenpaares P' mitquenchen.

## Patentansprüche

1. Einrichtung zur Quenchausbreitung für einen supraleitenden Magneten mit mindestens einem Paar supraleitender Spulen (3,4), mit welcher Einrichtung bei einem in einem Störungsfall auftretenden Normalleitendwerden (Quench) einer ersten bis dahin supraleitenden Spule des Spulenpaares auch die zweite Spule dieses Paares vom supraleitenden Betriebszustand in den normalleitenden Zustand mit Hilfe von thermisch mit den Spulen verbundenen Heizvorrichtungen zu überführen ist, **dadurch gekennzeichnet,** daß die Heizvorrichtungen magnetisch eng mit ihren jeweils zugeordneten Spulen (3, 4) gekoppelte Zusatzwicklungen (6, 7) aus mindestens einem diskreten Leiter (L) aus normalleitendem Material mit vorbestimmtem spezifischen elektrischen Widerstand ($\rho$) sind und daß die den beiden Spulen (3, 4) des Spulenpaares (P) zugeordneten beiden Zusatzwicklungen (6, 7) miteinander so kurzgeschlossen sind, daß die Stromflußrichtung (11) in der einen Zusatzwicklung (6) entgegengesetzt zur Stromflußrichtung (12) in der zweiten Zusatzwicklung (7) verläuft.

2. Quenchausbreitungseinrichtung nach Anspruch 1, **dadurch gekennzeichnet,** daß die Zusatzwicklungen (6, 7) aus mindestens einem isolierten band- oder drahtförmigen Leiter (L) aus elektrisch gut-leitendem Material bestehen, dessen elektrischer spezifischer Widerstand ($\rho$) bei 4,2 K zwischen $10^{-9}$ und $10^{-11}$ $\Omega$ .m liegt.

3. Quenchausbreitungseinrichtung nach Anspruch 2, **dadurch gekennzeichnet,** daß für den mindestens einen Leiter (L) der Zusatzwicklung (6, 7) ein Material vorgesehen ist, dessen Restwiderstandsverhältnis $\rho$(300 K)/ $\rho$(4,2 K) zwischen 50 und 500 liegt, wobei $\rho$ (T) der spezifische elektrische Widerstand bei der jeweiligen Temperatur (T) ist.

4. Quenchausbreitungseinrichtung nach einem der Ansprüche 1 bis 3, **dadurch gekennzeichnet,** daß der mindestens eine Leiter (L) der Zusatzwicklungen (6, 7) aus einem normalleitenden Material besteht, das als stabilisierendes Material für die Supraleiter dient, aus denen die zugeordneten supraleitenden Spulen (3, 4) aufgebaut sind.

5. Quenchausbreitungseinrichtung nach einem der Ansprüche 1 bis 4, **dadurch gekennzeichnet,** daß der mindestens eine Leiter (L) der Zusatzwicklungen (6, 7) aus Kupfer oder Aluminium besteht.

6. Quenchausbreitungseinrichtung nach einem der Ansprüche 1 bis 5, **dadurch gekennzeichnet,** daß die Zusatzwicklungen (6, 7) jeweils aus einer Lage mehrerer dicht gewickelter Windungen (w) des mindestens einen Leiters (L) bestehen.

7. Quenchausbreitungseinrichtung nach einem der Ansprüche 1 bis 6, **dadurch gekennzeichnet,** daß die Zusatzwicklungen (6, 7) jeweils einen Bereich der jeweils zugeordneten supraleitenden Spule (3 bzw. 4) abdecken, der eine axiale Mindestbreite (b) von 2 cm hat.

8. Quenchausbreitungseinrichtung nach einem der Ansprüche 1 bis 7, **dadurch gekennzeichnet,** daß das Spulenpaar (P) des Magneten (2, 20) aus symmetrisch zu einer Mittelebene (M) angeordneten und/oder aufgebauten, ringförmigen supraleitenden Spulen (3, 4) besteht.

9. Quenchausbreitungseinrichtung nach einem der Ansprüche 1 bis 8, **dadurch gekennzeichnet,** daß jede supraleitende Spule (3, 4) des Spulenpaares (P) aus mehreren Teilspulen zusammengesetzt ist.

10. Quenchausbreitungseinrichtung nach einem der Ansprüche 1 bis 9, **dadurch gekennzeichnet,** daß zwischen den supraleitenden Spulen (3, 4) eines ersten Spulenpaares (P) des Magneten (20) mindestens ein weiteres Paar (P') von supraleitenden Spulen (21, 22) angeordnet ist und daß an diesen Spulen (21, 22) des weiteren Spulenpaares (P') elektrische Heizelemente (24, 25) in gutem Wärmekontakt angebracht sind, die in mindestens einen der Verbindungsleiter (13, 14') geschaltet sind, welche zwischen den den supraleitenden Spulen (3, 4) des ersten Spulenpaares (P) zugeordneten Zusatzwicklungen (6, 7) verlaufen (Fig. 2).

11. Quenchausbreitungseinrichtung nach Anspruch 10, **dadurch gekennzeichnet,** daß der elektrische Serienwiderstand der Heizelemente (24, 25) das Ein- bis Zehnfache des elektrischen Serienwiderstandes der beiden Zusatzwicklungen (6, 7) beträgt.

12. Quenchausbreitungseinrichtung nach einem der Ansprüche 1 bis 11, **dadurch gekennzeichnet,** daß die Zusatzwicklungen (6, 7) gegenüber einem zur Kühlung der supraleitenden Spulen (3, 4) vorgesehenen kryogenen Medium thermisch isoliert sind.

## Claims

1. Quench-propagation device for a superconducting magnet having at least one pair of superconducting coils (3, 4), with which device when a first coil of the coil pair, which up to that point was superconducting, becomes normal-conducting (quench), as occurs in a case of disturbance, the second coil of this pair can also be converted from the superconducting operational state into the normal-conducting state with the aid of heating arrangements which are thermally connected to the coils, characterised in that the heating arrangements are auxiliary windings (6, 7) which are magnetically closely coupled with their respectively associated coils (3, 4) and consist of at least one discrete conductor (L) of normal-conducting material with predetermined specific electrical resistance ($\rho$) and in that the two auxiliary windings (6, 7) associated with the two coils (3, 4) of the coil pair (P) are short-circuited with each other in such a way that the direction of current flow (11) in one auxiliary winding (6) runs in opposition to the direction of current flow (12) in the second auxiliary winding (7).

2. Quench-propagation device according to claim 1, characterised in that the auxiliary windings (6, 7) consist of at least one insulated band-shaped or wire-shaped conductor (L) of material with high electrical conductivity, the electrical specific resistance ($\rho$) of which material lies at 4.2 K between $10^{-9}$ and $10^{-11}$ $\Omega$.m.

3. Quench-propagation device according to claim 2, characterised in that there is provided for the at least one conductor (L) of the auxiliary winding (6, 7) a material with a residual resistance ratio $\rho$ (300 K)/ $\rho$ (4.2 K ) lying between 50 and 500, wherein $\rho$ (T) is the specific electrical resistance at the respective temperature (T).

4. Quench-propagation device according to one of the claims 1 to 3, characterised in that the at least one conductor (L) of the auxiliary windings (6, 7) consists of a normal-conducting material which is used as a stabilizing material for the superconductors out of which the associated superconducting coils (3, 4) are constructed.

5. Quench-propagation device according to one of the claims 1 to 4, characterised in that the at least one conductor (L) of the auxiliary windings (6, 7) consists of copper or aluminium.

6. Quench-propagation device according to one of the claims 1 to 5, characterised in that the auxiliary windings (6, 7) each consist of one layer of several closely wound windings (w) of the at least one conductor (L).

7. Quench-propagation device according to one of the claims 1 to 6, characterised in that the auxiliary windings (6, 7) each cover a region of the respectively associated superconducting coil (3 or 4), which region has a minimum axial width (b) of 2 cm.

8. Quench-propagation device according to one of the claims 1 to 7, characterised in that the coil pair (P) of the magnet (2, 20) consists of annular superconducting coils (3, 4) which are arranged and/or set up symmetrically relative to a central plane (M).

9. Quench-propagation device according to one of the claims 1 to 8, characterised in that each superconducting coil (3, 4) of the coil pair (P) is made up of several coil sections.

10. Quench-propagation device according to one of the claims 1 to 9, characterised in that at least one additional pair (P') of superconducting coils (21, 22) is arranged between the superconducting coils (3, 4) of a first coil pair (P) of the magnet (20) and in that provided on these coils (21, 22) of the additional coil pair (P') there are electrical heating elements (24, 25) in good thermal contact, which heating elements are connected to at least one of the connecting conductors (13, 14') which run between the auxiliary windings (6, 7) associated with the superconducting coils (3, 4) of the first coil pair (P) (Figure 2).

11. Quench-propagation device according to claim 10, characterised in that the electrical series resistance of the heating elements (24, 25) is 1 to 10 times greater than the electrical series resistance of the two auxiliary windings (6, 7).

12. Quench-propagation device according to one of the claims 1 to 11, characterised in that the auxiliary windings (6, 7) are thermally insulated from a cryogenic medium provided for the purpose of cooling the superconducting coils (3, 4).

## Revendications

1. Dispositif pour la propagation de la transition de l'état supraconducteur à l'état normalement conducteur (quench) pour un élément supraconducteur comportant au moins un couple de bobines supraconductrices (3,4), et dans lequel lors d'un passage à l'état normalement conducteur, qui se produit dans le cas d'une perturbation, d'une première bobine, jusqu'alors supraconductrice, du couple de bobines, également la seconde bobine de ce couple doit être amenée de l'état de fonctionnement supraconducteur dans l'état normalement conducteur à l'aide de dispositifs de chauffage raccordés thermiquement aux bobines, caractérisé par le fait que les dispositifs de chauffage sont des enroulements supplémentaires (6,7) accouplés selon un couplage magnétique serré aux bobines (3,4) qui leur sont respectivement associées et sont constitués par au moins un conducteur discret (L) réalisé en un matériau normalement conducteur et possédant une résistance électrique spécifique prédéterminée (r) et que les deux enroulements supplémentaires (6,7), qui sont associés aux deux bobines (3,4) du couple de bobines (P), sont court-circuités entre elles de sorte que la direction du flux de courant (11) dans un enroulement supplémentaire (6) est opposée à la direction du flux de courant (12) dans le second enroulement supplémentaire (7).

2. Dispositif de propagation de la transition de l'état supraconducteur à l'état normalement conducteur (quench) suivant la revendication 1, caractérisé par le fait que les enroulements supplémentaires (6,7) sont constitués par au moins un conducteur isolé en forme de bande ou de fil (L) et réalisé en un matériau bon conducteur de l'électricité, dont la résistance électrique spécifique (r) a 4,2 K est comprise entre $10^{-9}$ et $10^{-11}$ W.m.

3. Dispositif de propagation de la transition de l'état supraconducteur à l'état normalement conducteur (quench) suivant la revendication 2, caractérisé par le fait que pour l'au moins un conducteur (L) de l'enroulement supplémentaire (6,7), il est prévu d'utiliser un matériau dont le rapport des résistances résiduelles r(300 K)-/r(4,2 K) est compris entre 50 et 500, r(T) désignant la résistance électrique spécifique à la température respective (T).

4. Dispositif de propagation de la transition de l'état supraconducteur à l'état normalement conducteur (quench) suivant l'une des revendications 1 à 3, caractérisé par le fait que l'au moins un conducteur (L) des enroulements supplémentaires (6,7) est réalisé en un matériau normalement conducteur, qui est utilisé comme matériau stabilisateur pour les supraconducteurs, dont sont constituées les bobines supraconductrices associées (3,4).

5. Dispositif de propagation de la transition de l'état supraconducteur à l'état normalement conducteur (quench) suivant l'une des revendications 1 à 4, caractérisé par le fait que l'au moins un conducteur (L) des enroulements supplémentaires (6,7) est formé de cuivre ou d'aluminium.

6. Dispositif de propagation de la transition de l'état supraconducteur à l'état normalement conducteur (quench) suivant l'une des revendications 1 à 5, caractérisé par le fait que les enroulements supplémentaires (6,7) sont constitués respectivement par une couche de plusieurs spires (w), enroulées d'une manière serrée, du moins un conducteur (L).

7. Dispositif de propagation de la transition de l'état supraconducteur à l'état normalement conducteur (quench) suivant l'une des revendications 1 à 6, caractérisé par le fait que les enroulements supplémentaires (6,7) recouvrent respectivement une zone de la bobine supraconductrice respectivement associée (3 ou 4), qui possède une largeur axiale minimale (b) égale à 2 cm.

8. Dispositif de propagation de la transition de l'état supraconducteur à l'état normalement conducteur (quench) suivant l'une des revendications 1 à 7, caractérisé par le fait que le couple de bobines (P) de l'aimant (2,20) est constitué par des bobines annulaires supraconductrices (3,4) disposées et/ou agencées d'une manière symétrique par rapport à un plan médian (M).

9. Dispositif de propagation de la transition de l'état supraconducteur à l'état normalement conducteur (quench) suivant l'une des revendications 1 à 8, caractérisé par le fait que chaque bobine supraconductrice (3,4) du couple de bobines (P) est constituée par la réunion de plusieurs bobines partielles.

10. Dispositif de propagation de la transition de l'état supraconducteur à l'état normalement conducteur (quench) suivant l'une des revendications 1 à 9, caractérisé par le fait qu'entre les bobines supraconductrices (3,4) d'un premier couple de bobines (P) de l'aimant (20) est disposé au moins un autre couple (p') de bobines supraconductrices (21,22), et que ces bobines (21,22) de l'autre couple de bobines (p') sont placées, en bon contact thermique avec des éléments de chauffage électriques (24,25), qui sont branchés dans au moins l'un des conducteurs de jonction (13,14'), qui s'étendent entre les enroulements supplémentaires (6,7) associés aux bobines supraconductrices (3,4) du premier couple de bobines (P) (figure 2).

11. Dispositif de propagation de la transition de l'état supraconducteur à l'état normalement conducteur (quench) suivant la revendication 10, caractérisé par le fait que la résistance électrique en série des éléments de chauffage (24,25) est comprise entre une et dix fois la résistance électrique en série des deux enroulements supplémentaires (6,7).

12. Dispositif de propagation de la transition de l'état supraconducteur à l'état normalement conducteur (quench) suivant l'une des revendications 1 à 11, caractérisé par le fait que les enroulements supplémentaires (6,7) sont isolés thermiquement par rapport à un milieu cryogénique prévu pour refroidir les bobines supraconductrices (3,4).

FIG 1

FIG 2